# EUROPEAN PATENT APPLICATION

(11) **EP 4 475 194 A1**
(43) Date of publication of application: **11.12.2024**
(21) Application number: 23178558.5
(22) Date of filing: 09.06.2023
(51) Int. Cl.: H01L 31/0224, H01L 31/028, H01L 31/036, H01L 31/102, G02B 6/12, H01L 31/0232

(54) **A 2D MATERIAL-METAMATERIAL PHOTODETECTOR**

(71) Applicant: ETH Zurich, 8092 Zurich (CH)
(72) Inventor: Köpfli, Stefan Martin, 5034 Suhr (CH); Dorodnyy, Alexander, 8093 Birmensdorf (CH); Baumann, Michael, 8051 Zürich (CH); Leuthold, Juerg, 8173 Neerach (CH)
(74) Representative: Gygi, Andreas

(57) **Abstract**

A photodetector (8) comprises: a multilayer stack comprising a resonator layer (1) which is in contact with a 2D material layer (3) which is in contact with an insulator spacer layer (4), wherein the multilayer stack is configured to absorb an optical signal and to convert the absorbed optical signal into charge carriers and to enable electrically measuring the charge carriers, wherein the 2D material layer (3) includes one of: a semiconducting material, a 2D material, a Van Der Waals heterostructure material, and a semimetal material, wherein the resonator layer (1) comprises first and second contact lines (1a1, 1a2) which have an alternating configuration.

## Description

### FIELD OF THE INVENTION

The present invention relates to a 2D material-meta material photodetector. In particular, the present invention relates to an infrared 2D material-meta material photodetector operating at infrared wavelengths. In particular, the present invention relates to a high-speed 2D material-metamaterial photodetector.

### BACKGROUND ART

Photodetectors convert a signal from an optical domain into an electrical domain. Requirements for photodetectors are that they must be cheap, be compact, have low power consumption, have a predefined conversion efficiency, operate in a predefined spectral broadband window and have a fast response. The majority of photodetectors absorb an optical signal of a specific wavelength range and convert the absorbed optical signal in part into charge carriers. The charge carriers can be detected by electrically measuring a change of a voltage or a current.

Infrared photodetectors operate at an infrared wavelength and are widely used in optical communication links, sensing applications, imaging, etc. Most implementations of infrared photodetectors rely on semiconductor devices. They operate by using a bandgap of an active material to absorb the optical signal, wherein a bias voltage is applied to the active material in order to extract charge carriers generated by the absorption of the optical signal. Typically, these devices rely on expensive crystalline materials that are difficult to manufacture and integrate. Efficient and high-speed performance is determined by the semiconductor material. Further, they have a trade-off between active area size, saturation power and bandwidth.

2D materials refer to crystalline solids consisting of a single layer of atoms. 2D materials can include more than one layer of atoms, with in-plane interatomic forces higher than out of plane forces. Research towards 2D materials as active materials in infrared photodetectors is on-going. Typically, such photodetectors rely on photonic integrated circuits (waveguides) to increase the interaction length with the 2D materials and the absorption of photons. These approaches often have limited optical saturation powers, work within a relatively narrow spectral window and come at increased costs. Furthermore, highest operation bandwidths so far have been limited to around 100 GHz and they often required a bias voltage.

US20220307974A1 shows that a photodetector's poor active semiconductor medium quality can be compensated by co-integration into a metamaterial perfect absorber (MPA) structure. A resonator layer simultaneously acts as electrodes.

S. M. Koepfli et al., >500 GHz Bandwidth Graphene Photodetector Enabling Highest-Capacity Plasmonic-to-Plasmonic Links, 2022 European Conference on Optical Communication (ECOC), Basel, Switzerland, 2022, pp. 1-4 discloses a metamaterial enhanced graphene photodetector. Graphene is placed in a metamaterial perfect absorber (MPA). High-speed operation under near-infrared illumination is enabled by combining an interconnected resonator MPA with graphene. Alternating contact metals in the resonator layer enable zero-bias operation.

### DISCLOSURE OF THE INVENTION

There may be a need for an improved 2D material-meta material photodetector. In particular, there may be a need for an improved 2D material-meta material photodetector with improved efficiency. In particular, there may be a need for an improved 2D material-meta material photodetector with improved noise characteristics. In particular, there may be a need for an improved 2D material-metamaterial photodetector with improved spectral adaptability. In particular, there may be a need for an improved 2D material-meta material photodetector with improved polarization sensitivity. In particular, there may be a need for an improved 2D material-meta material photodetector with improved fabricability.

Such a need may be met with the subject-matter of the independent claims. Advantageous embodiments are defined in the dependent claims.

Ideas underlying embodiments of the present invention may be interpreted as being based, inter alia, on the following observations and recognitions.

An aspect of the invention relates to a photodetector, comprising: a multilayer stack comprising a resonator layer which is in contact with a 2D material layer which is in contact with an insulator spacer layer, wherein the multilayer stack is configured to absorb an optical signal and to convert the absorbed optical signal into charge carriers and to enable electrically measuring the charge carriers, wherein the 2D material layer includes one of: a semiconducting material, a 2D material, a Van Der Waals heterostructure material, and a semimetal material, wherein the resonator layer comprises first and second contact lines which have an alternating configuration. The photodetector enables various applications. High bandwidths are enabled.

In some embodiments, the 2D material layer is not a single layer of graphene.

In some embodiments, the insulator spacer layer is in contact with a backside reflector layer. For example, a modified metamaterial perfect absorber is enabled.

In some embodiments, the photodetector is arranged in a device architecture comprising a ground line and a signal line which are in contact with the resonator layer, wherein the insulator spacer layer is in contact with a backside reflector layer, further comprising a gate line which is in contact with the backside reflector layer, wherein there is no overlap between the gate line and the signal line. High bandwidths are enabled.

In some embodiments, the insulator spacer layer is in contact with a backside reflector layer, wherein the resonator layer includes first contact lines and second contact lines having different materials and being arranged in an alternating fashion, wherein an electrical measurement instrumentation is connected between the first contact lines and the second contact lines, and wherein a voltage source is connected to the second contact lines and to the backside reflector layer, wherein the voltage of the voltage source is adjusted to maximize charge carrier velocity. High bandwidths are enabled.

In some embodiments, the photodetector is configured according to a procedure to optimize a measured electrical current on the basis of an equivalent circuit of the photodetector.

In some embodiments, a 2D material insulator is arranged between the spacer layer and the 2D material layer.

In some embodiments, the resonator layer includes first resonators connected to contact lines, wherein second resonators are arranged in an orthogonal fashion with respect to the first resonators, wherein the second resonators are connected to the contact lines.

In some embodiments, the resonator layer includes a plurality of resonators having different geometries.

In some embodiments, a frontside 2D material insulator which is in contact with the 2D material layer in a configuration which enables that the 2D material layer remains in contact with the resonator layer.

In some embodiments, the resonator layer includes first contact lines connected to resonators, and wherein the resonator layer includes second contact lines without resonators.

In some embodiments, the spacer layer is in contact with an optical waveguide.

### BRIEF DESCRIPTION OF THE DRAWINGS

In the following, advantageous embodiments of the invention will be described with reference to the enclosed drawings. However, neither the drawings nor the description shall be interpreted as limiting the invention.
Figs. 1A, 1B, 1C show scanning electron micrographs of a photodetector according to the present invention at varying magnifications.
Fig. 1C' schematically shows a top view and a cross-section comprising a unit cell of a photodetector according to the present invention.
Fig. 2 schematically shows a top view and a cross-section of a photodetector which is incorporated in a full device architecture.
Fig. 3 schematically shows a cross-section view of a photodetector according to the present invention connected to a measurement instrumentation and a voltage source.
Fig. 4 schematically illustrates an equivalent circuit of a photodetector according to the present invention.
Fig. 5 schematically shows a photodetector according to the present invention with an 2D material insulator.
Fig. 6 schematically shows a unit cell 2 of a photodetector 8 according to the present invention with additional resonators.
Fig. 7A, 7B schematically show a unit cells of a photodetector 8 according to the present invention with resonators having different geometries.
Fig. 8 schematically shows a cross-section of a photodetector according to the present invention with a frontside 2D material insulator.
Fig. 9 schematically shows a unit cell of a photodetector according to the present invention enabling simplified fabrication.
Fig. 10, Fig. 10A schematically show a photodetector according to the present invention which is in contact with an optical waveguide.

The figures are only schematic and not to scale. Same reference signs refer to same or similar features.

### MODE(S) FOR CARRYING OUT THE INVENTION

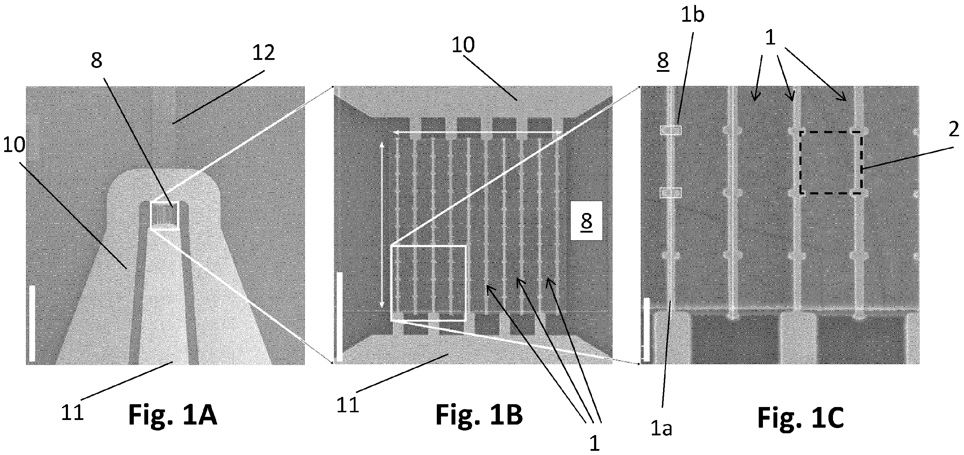

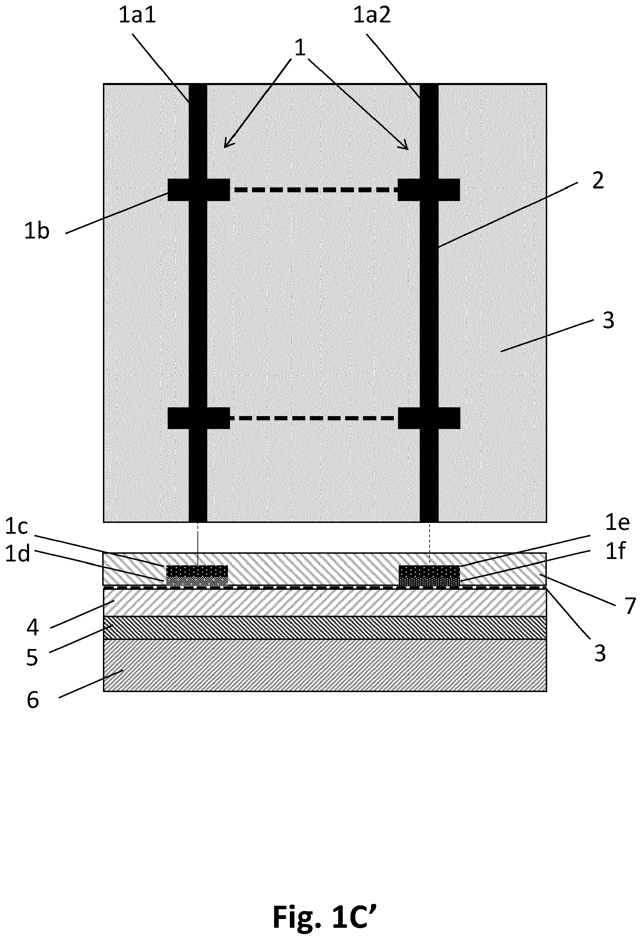

Figs. 1A, 1B, 1C show scanning electron micrographs of a photodetector 8 according to the present invention at varying magnifications (50 micrometer, 5 micrometer, 1 micrometer scalebars).

Fig. 1A shows the photodetector 8 connected to a ground line 10, to a signal line 11 and to a gate line 12. Thus, the photodetector 8 is included in a full device architecture.

Fig. 1B shows a magnified view of an active area of the photodetector 8. The active area is configured to receive an optical signal in direction into a plane of Fig. 1B. Fig. 1B shows a resonator layer 1 from the top. The resonator layer 1 includes contact lines 1a (which will be described in more detail below), which are connected in an alternating fashion to the ground line 10 and the signal line 11.

Fig. 1C shows a magnified view of a unit cell 2 of the photodetector 8. Figs. 1B, 1C show that the photodetector 8 comprises an array of unit cells 2. Fig. 1C shows resonators 1b. Fig. 1C shows first and a second contact lines 1a1, 1a2 which are connected to the resonators 1b. The array of unit cells 2 can e.g. be quadratic, rectangular, hexagonal or linear. For example, 9x9 unit cells 2 can be arranged. For example, 12x9 or 9x12 unit cells 2 can be arranged. For example, 1x6 or 6x1 unit cells 2 can be arranged. For example, any number of unit cells 2 can be arranged. Accordingly, a plurality of unit cells 2 can be arranged.

The unit cells 2 have a quadratic form. At the corners, the resonator layer 1 includes resonators 1b. At two opposite sides, first and second contact lines 1a1, 1a2 are arranged, each contacting two resonators 1b. Accordingly, a unit cell 2 has four resonators 1b and a first and second contact line 1a1, 1a2, wherein the first contact line 1a1 is connected to two resonators 1b and wherein the second contact line 1a2 is connected to two resonators 1b.

Fig. 1C' schematically shows a top view and a cross-section comprising a unit cell 2 of a photodetector 2 according to the present invention.

As schematically shown in the cross-section of Fig. 1C', the photodetector 8 comprises a multilayer stack. The multilayer stack of the photodetector 8 comprises an insulator spacer layer 4, which is in contact with a 2D material layer 3, which is in contact with a resonator layer 1.

Furthermore, a backside reflector 5 can be in contact with the insulator spacer layer 4.

Furthermore, the backside reflector layer 5 can be in contact with a substrate 6.

Furthermore, he 2D material layer 3 and the resonator layer 1 can be in contact with a frontside insulator layer 7.

As illustrated in the top view of Fig. 1C', the resonator layer 1 includes resonators 1b. The resonator layer 1 includes first and second contact lines 1a1, 1a2 for connecting the resonators 1b. As described earlier, the contact lines 1a1, 1a2 can be connected in an alternating fashion to the ground line 10 and the signal line 11. For example, the resonators 1b can relate to dipole resonators.

As illustrated in the cross-section of Fig. 1C', the first and second contact lines 1a1, 1a2 have an alternating configuration. In an alternating fashion, the contact lines 1a1, 1a2 include a first contact layer 1d and a second contact layer 1f which are in contact with the 2D material layer 3, and a first capping layer 1c and a second capping layer 1e which are respectively in contact with the first contact layer 1d and the second contact layer 1f.

For example, a photodetector 8 can be fabricated by deposing the backside reflector layer 5 on a substrate, by deposing the spacer layer 4 on the backside reflector layer 5, by deposing the 2D material layer 3 on the spacer layer 4, by deposing the resonator layer 1 on the 2D material layer 3, and by deposing frontside insulator layer 7 on the 2D material layer 3 and the resonator layer 1.

For example, a photodetector 8 can relate to a modified metamaterial perfect absorber (MPA).

For example, the resonant layer 1 provides a resonant response to the impinging optical signal. The spacer layer 4 and reflector layer 5 allow for impedance correction to minimize reflection of the overall layer stack. The reflector layer 5 eliminates transmission. The full stack of resonant layer 1, spacer layer 4 and reflector layer 5 thereby increases the absorption of the optical signal as both transmission and reflection are minimized.

The multilayer stack has a spectral resonant absorption enhancement, wherein a part of the absorption can occur in the 2D material layer 3. The interconnected resonators 1b and the 2D material form a conductive channel.

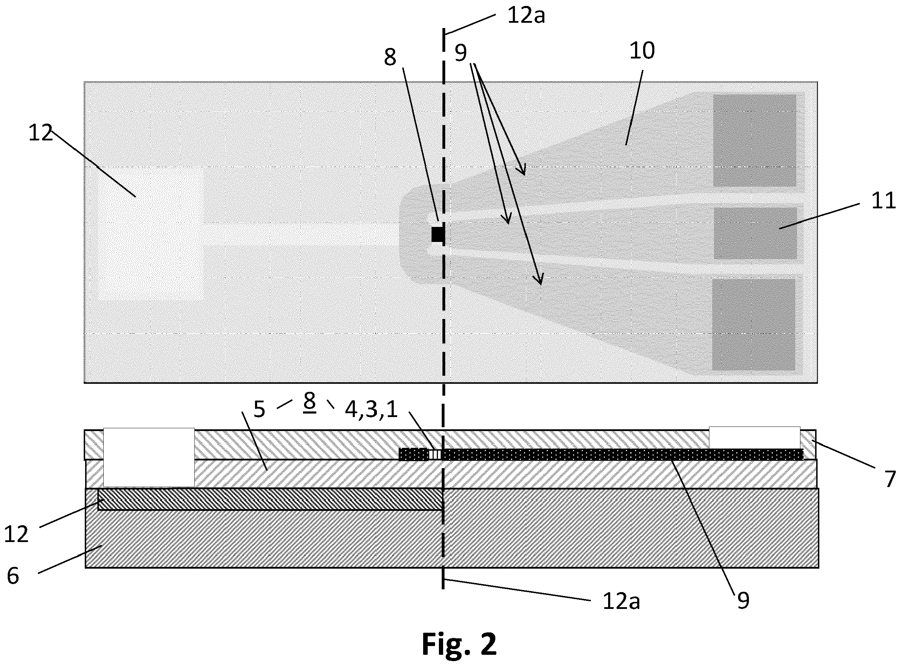

Fig. 2 schematically shows a top view and a cross-section of a photodetector 8 which is incorporated in a full device architecture. The top view of Fig. 2 corresponds to Fig. 1A. As illustrated in the top view of Fig. 2, the photodetector 8 is connected on one side to the ground line 10, and on an opposite side to the signal line 11, which form coplanar waveguides 9. As illustrated in Fig. 2, the gate line 12 is in contact with the backside reflector layer 5. For example, the gate line 12 is arranged in a recess of the substrate 6. The photodetector 8 is covered with a frontside insulator layer 7. The ground line 10, the signal line 11 and the gate line 12 are accessible via recesses of the frontside insulator layer 7 respectively the backside reflector layer 5.

Alternatively, access via a substrate 6 is possible. The active gate line 12 strikes a plane 12a which is orthogonal to the contact lines 1a and strikes the contact between the active layer 1 and the signal line 11. As illustrated in Fig. 2, the gate line 12 does not extend in a horizontal direction the contact between the resonator layer 1 and the signal line 11. As illustrated in Fig. 2, there is no overlap between the gate line 12 and the signal line 11. Lower parasitic capacitances and higher operation speeds are enabled.

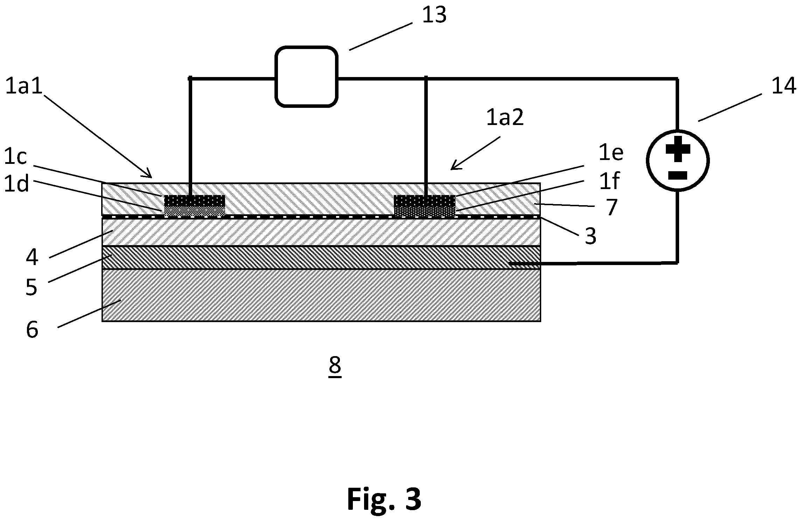

Fig. 3 schematically shows a cross-section view of a photodetector 8 according to the present invention. As described earlier and further illustrated in Fig. 3, first contact lines 1a1 and second contact lines 1a2 are arranged in an alternating fashion. An electrical measurement instrumentation 13 is connected between the first contact lines 1a1 and the second contact lines 1a2. A voltage source 14 is connected between the second contact lines 1a2 and the backside reflector layer 5, which is used as a third terminal and designated as "gate" in the present disclosure. The gate enables optimizing the photo-response and the frequency bandwidth. The thickness of the spacer layer 4 can be optimized for high absorption under the constraint of a low gate-voltage (e.g. less than 10V) operation. The gate-voltage is set to maximize carrier velocity which minimizes carrier transit time and maximizes the frequency response. The gate-voltage does not necessarily induce high doping to minimize recombination time. The gate voltage can depend on a position of a Dirac point and the metals involved. The gate voltage can depend on a thickness of the spacer layer 4 and the material of the spacer layer 4.

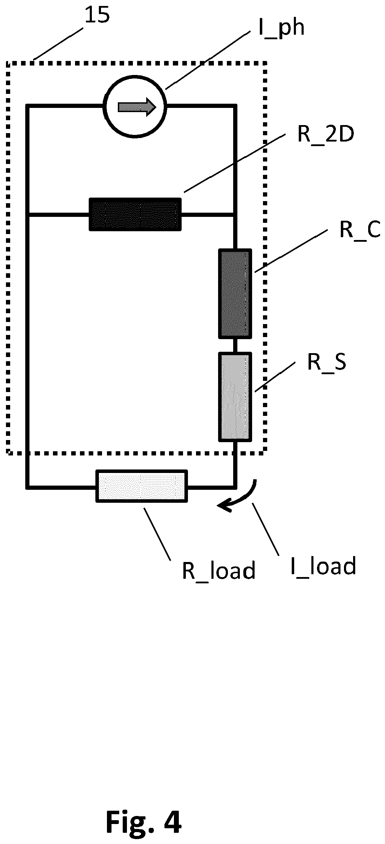

Fig. 4 schematically illustrates an equivalent circuit 15 of a photodetector 8 according to the present invention. The equivalent circuit 15 includes a current source I_ph which is connected in parallel to a channel resistance R_2D of the 2D material layer 3. The current source I_ph is serially connected to a contact resistance R_C of the contact between the 2D material layer 3 and the resonator layer 1, a structure resistance R_S of the resonator layer 1, in particular the contact lines 1a and the resonators 1b, and a measurement instrumentation resistance R_load. The current source I_ph relates to the generated photocurrent. The measurement instrumentation resistance R_load relates to the electrical measurement instrumentation 13 (cf. Fig. 3). A measured electrical current I_load is received at the measurement instrumentation resistance R_load and relates to an externally detected signal of the photodetector.

According to the present invention, on the basis of the equivalent circuit 15, the photodetector 8 is configured according to a procedure to maximize the measured electrical current I_load under illumination.

The resistance R_PD of the photodiode 8 is the sum: R_PD = R_2D + RC + R_S. Accordingly, the measured electrical current I_load amounts to I_load = I_load * R_2D/(R_PD + R_load).

For example, the current of the current source I_ph can be increased by optimizing internal and external quantum efficiencies (e.g., absorption, absorption distribution, carrier transit time, etc.) of the photodetector.

For example, the resistance of the channel resistance R_2D of the 2D material layer 3 can be increased (e.g., by etching of the 2D material to increase its resistance, using a semiconducting material, etc.).

For example, the resistance of the channel resistance R_2D can be increased for one current direction (e.g., forming a Schottky contact to enable a diode like behavior, etc.).

For example, the resistance of the structure resistance R_S can be decreased by choosing conductors with higher conductivity, by selecting different structure geometries, etc.

For example, the resistance of the contact resistance R_C can be decreased by changing the composition of the resonator layer 1 with lower contact resistance, patterning of the 2D material, etc.

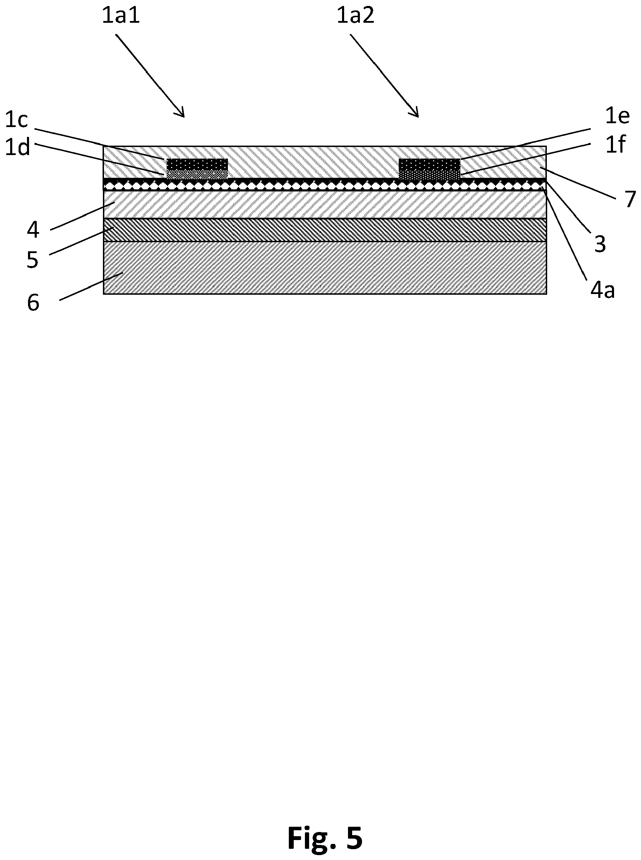

Fig. 5 schematically shows a photodetector 8 according to the present invention. A 2D material insulator 4a is arranged between the spacer layer 4 and the 2D material layer 3 for improving material characteristics of the 2D material layer 3.

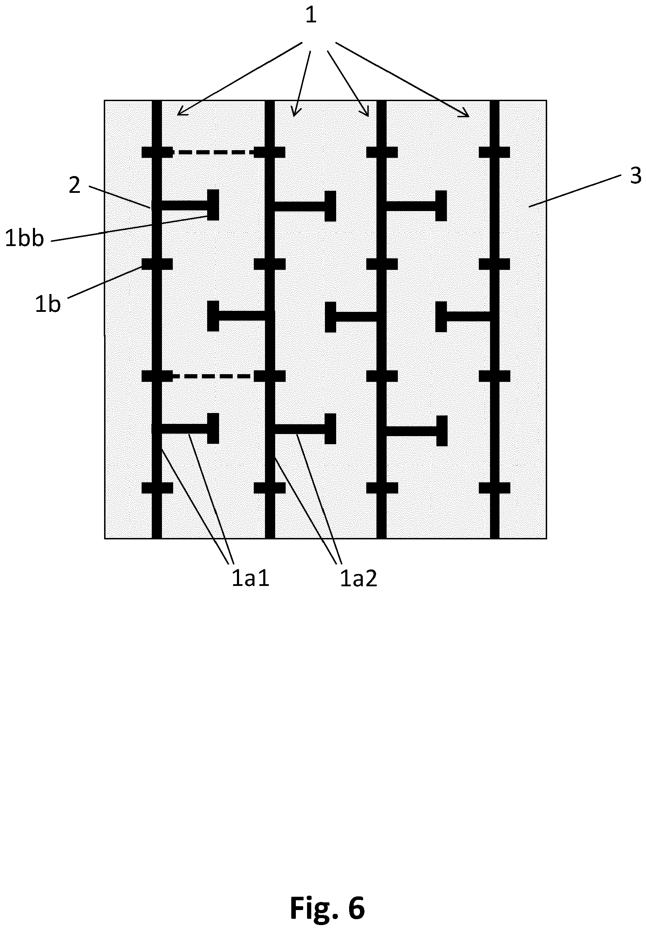

Fig. 6 schematically shows a unit cell 2 of a photodetector 8 according to the present invention. The resonator layer 1 includes first resonators 1b connected to first and second contact lines 1a1, 1a2. Second resonators 1bb are arranged in an orthogonal fashion with respect to the first resonators 1b. The second resonators 1bb are connected to the contact lines 1a1, 1a2. Thus, the second resonators 1bb are arranged perpendicularly to the first resonators 1b. In direction of the contact lines 1a1, 1a2, the second resonators 1bb are arranged alternatingly on different sides with respect to the contact lines 1a. Perpendicularly oriented resonators 1b, 1bb enable polarization independent resonant enhancement of the absorption, where alternatingly contacting the second resonators 1bb enables more efficient carrier extraction.

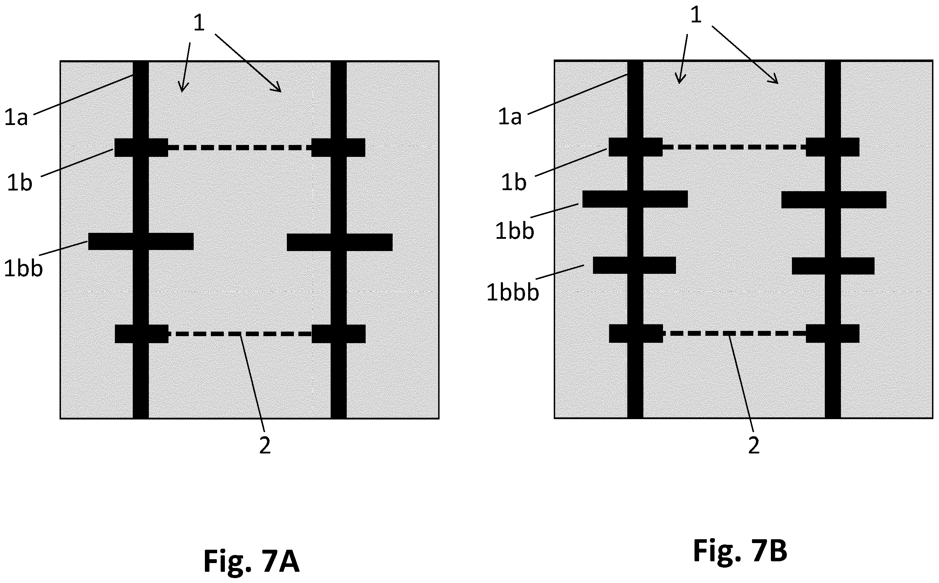

Fig. 7A, 7B schematically show a unit cells 2 of a photodetector 8 according to the present invention. Fig. 7A shows a unit cell 2 with first resonators 1b and second resonators 1bb connected to connection lines 1a. Fig. 7B shows a unit cell 2 with first resonators 1b, second resonators 1bb and third resonators 1bbb connected to connection lines 1a. The first, second, third resonators 1b, 1bb, 1bbb have different geometries for enabling a multiresonant enhancement of the spectral absorption and photocurrent generation, which can be used for detection of light over a broader spectral range or for selective detection of specific wavelength regions. Of course, more than just 3 variations of resonators can be arranged in general.

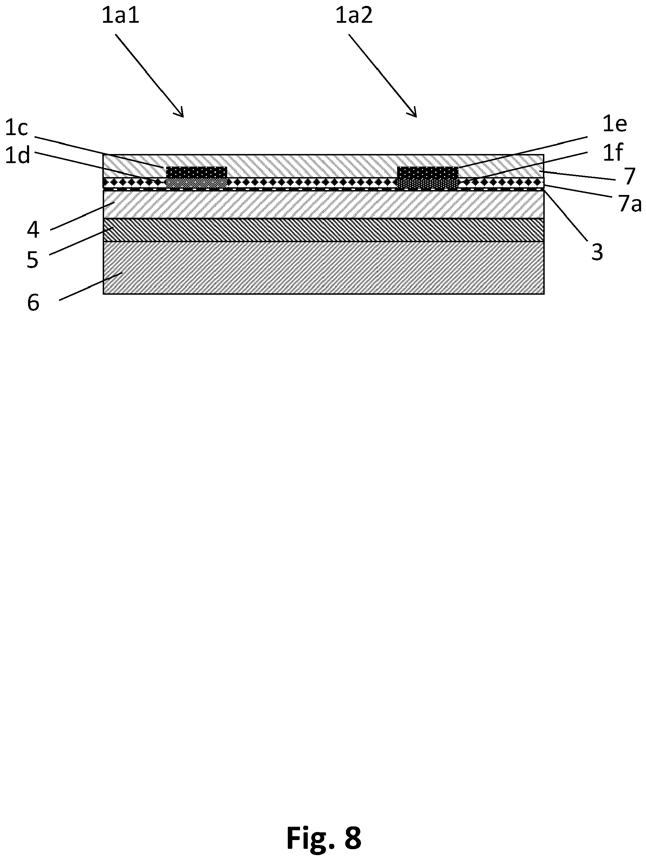

Fig. 8 schematically shows a cross-section of a photodetector 8 according to the present invention. A frontside 2D material insulator 7a is arranged between the frontside reflector layer and the 2D material layer 3. The frontside 2D material insulator 7 is configured that the active 2D material layer 3 remains in contact with the resonator layer 1, but properties of the active 2D material layer 3 can be beneficially changed. In addition, the growth of the encapsulation layer 7 can be promoted by the inclusion of the 2D material insulator 7a.

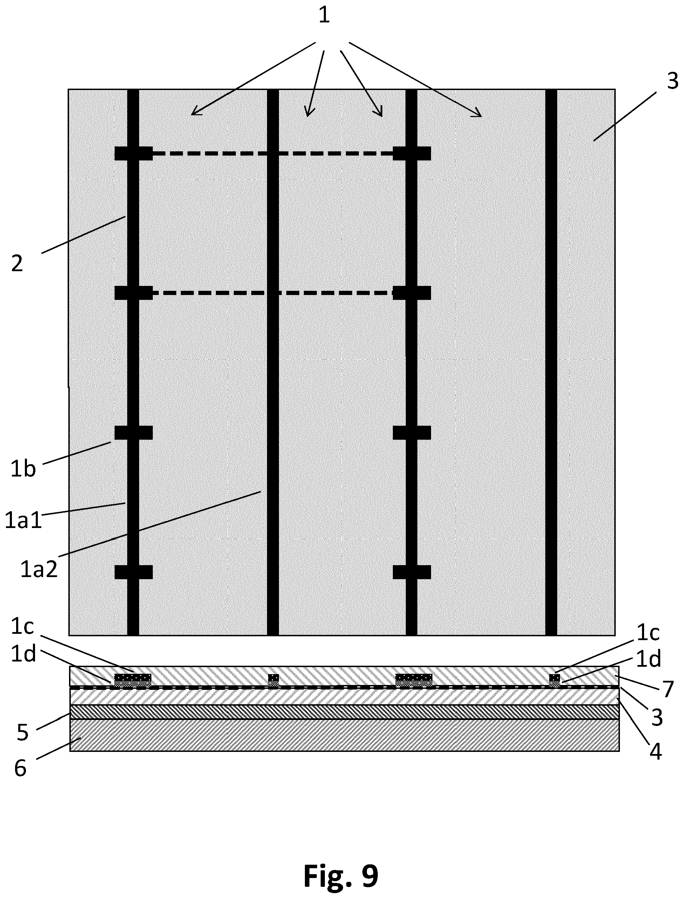

Fig. 9 schematically shows a unit cell 2 of a photodetector 8 according to the present invention. The resonant layer 1 includes first and second contact lines 1a1, 1a2. At the first contact lines 1a1, resonators 1b are arranged. The second contact lines 1a2 are without resonators. All contact lines 1a1, 1a2 include a first contact layer 1d which is in contact with the 2D material layer, and first capping layer 1c arranged on the first contact layer 1d. Thus, the contact lines 1a1, 1a2 have the same structure. Fabrication requires one fabrication step less, and is therefore simplified.

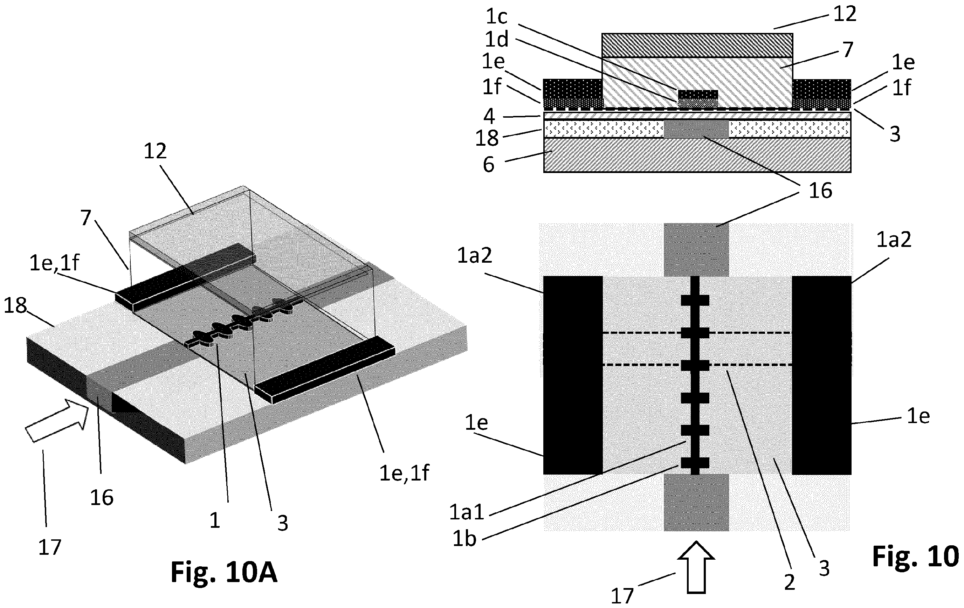

Figs. 10, 10A schematically show a photodetector 8 which is in contact with an optical waveguide 16. The photodetector 8 includes a spacer layer 4, a2D material layer 3 and a resonator layer 1. The resonator layer 1 is linear (e.g., has 6x1 unit cells 2). The resonator layer 1 includes a first contact line 1a1 which includes a first capping layer 1c, which is in contact with a first contact layer 1d, which is in contact with the 2D material layer 3. For example, the optical waveguide 16 is arranged on a substrate 2. For example, an optical waveguide cladding/planarization 18 is arranged. For example, an insulator layer 7 is in contact with the first capping layer 1c, the first contact layer 1f and the 2D material layer 3. For example, a gate layer 12 is in contact with the insulator layer 7. At sides of the insulator layer 7, second contact lines 1a2 are arranged which include a second contact layer 1f is in contact with the 2D material layer 3, and a second capping layer 1e is in contact with the second contact layer. For example, the optical waveguide cladding/planarization 18 and the waveguide 16 are disposed on the substrate 6, the spacer layer 4 disposed on the optical waveguide cladding/planarization 18 and the waveguide 16, the 2D material layer 3 is disposed on the spacer layer 4, the first and second contact layer 1d, 1f are disposed on the 2D material layer 3, the first and second capping layer 1c, 1e are disposed on the first and second contact layer 1d, 1f, the insulator layer 7 is disposed on the 2D material 3 and the first contact layer 1d and the first capping layer 1c, and the gate layer 12 is disposed on the insulator layer 7. For operating the photodetector 8, the second contact layer 1e and/or the second capping layer 1e can be connected to a ground line, the contact line 1a of the resonator layer 1 can be connected to a signal line, and the gate layer 12 is in contact with a gate line.

For example, the resonant layer 1 provides a resonant response to the impinging optical signal 17 which is guided by the optical waveguide 16. The resonant layer 1 confines the optical field, induces absorption in the 2D material layer 3. A signal line 11 can be in contact with the resonant layer 1. Fig. 10 illustrates ground lines as end contacts left and right, but repeating elements of resonators 1 can be used as ground lines as presented in the photodetector 8.

The resonator layer 1 can include and is not limited to gold, silver, aluminum, copper, palladium, tungsten, platinum, titanium, chromium, nickel, etc.

The contact line 1a can include and is not limited to gold, silver, aluminum, copper, palladium, tungsten, platinum, titanium, chromium, nickel, etc.

The resonators 1b, 1bb, 1bbb can include and is not limited to gold, silver, aluminum, copper, palladium, tungsten, platinum, titanium, chromium, nickel, etc. The shape of these resonators may include but is not limited to dipole antenna, bow-tie antenna, leave clover, patch antenna,....

The first contact layer 1d and the second contact layer 1f can include and is not limited to gold, silver, etc. The first contact layer 1d and the second contact layer 1f of different contact lines 1a can include alternating materials.

The first capping layer 1c and the second capping layer 1e can include and is not limited to gold, silver, etc.

The first contact layer 1d, the second contact layer 1f, the first contact layer 1d, and the second contact layer 1f can enable n- and p-type contact doping.

The 2D material layer 3 could e.g. be realized by transition metal dichalcogenide (TMDCs), semiconducting or metallic dichalcogenides, perovskite-type and many other monolayered materials. Examples of which are e.g. PtSe2 platinum diselenide, PdSe2 palladium diselenide, MoTe2 molybdenum ditelluride, MoS2, WSe2, etc. Likewise it could be realized by any of the following materials such as monocrystalline graphene, multilayer graphene stack, rotationally stacked graphene, graphene nanoribbons. Further, it could be realized by a stacking a combination of all of the above forming so-called Van der Waals heterostructures, etc. For example, the 2D material layer 3 can absorb infrared light.

The spacer layer 4 can include and is not limited to aluminum oxide, hafnium oxide, silicon oxide, silicon nitride, titanium oxide, etc.

The 2D material insulator (4a) can e.g. include but is not limited to hBN.

The frontside insulator layer 7 can include and is not limited to aluminum oxide, hafnium oxide, silicon oxide, silicon nitride, titanium oxide, etc.

Finally, it should be noted that the term "comprising" does not exclude other elements or steps and the "a" or "an" does not exclude a plurality. Also elements described in association with different embodiments may be combined. It should also be noted that reference signs in the claims should not be construed as limiting the scope of the claims.

### LIST OF REFERENCE SIGNS

| | | | |
|---|---|---|---|
| 1 | resonator layer | 1a1 | first contact line |
| 1a2 | second contact lines | | |
| 1b, 1bb, 1bbb | resonators | 1c | first capping layer |
| 1d | first contact layer | 1e | second capping layer |
| 1f | second contact layer | 2 | unit cell |
| 3 | 2D material layer | 4 | spacer layer |
| 4a | 2D material insulator layer | 5 | backside reflector layer |
| 6 | substrate | 7 | frontside insulator layer |
| 7a | frontside 2D material insulator | 8 | photodetector |
| 9 | coplanar waveguides | 10 | ground lines |
| 11 | signal line | 12 | gate line |
| 12a | end of gate line | | |
| 13 | electrical measurement instrumentation | 14 | voltage source |
| 15 | equivalent circuit of photodetector | I_ph | current source |
| R_2D | channel resistance | R_C | contact resistance |
| R_S | structure resistance | I_load | measured electrical current |
| R_load | measurement instrumentation resistance | | |
| 16 | optical waveguide | 17 | optical signal |
| 18 | optical waveguide cladding/planarization | | |

## Claims

1. A photodetector (8), comprising:
a multilayer stack comprising a resonator layer (1) which is in contact with a 2D material layer (3) which is in contact with an insulator spacer layer (4), wherein the multilayer stack is configured to absorb an optical signal and to convert the absorbed optical signal into charge carriers and to enable electrically measuring the charge carriers, wherein the 2D material layer (3) includes one of:
a semiconducting material, a 2D material, a Van Der Waals heterostructure material, and a semimetal material,
wherein the resonator layer (1) comprises first and second contact lines (1a1, 1a2) which have an alternating configuration.

2. The photodetector (8) according to claim 1, wherein the 2D material layer (3) is not a single layer of graphene.

3. The photodetector (8) according to claim 1 or 2, wherein the insulator spacer layer (4) is in contact with a backside reflector layer (5).

4. The photodetector (8) according to one of claims 1 to 3 arranged in a device architecture comprising a ground line (10) and a signal line (11) which are in contact with the resonator layer (1), wherein the insulator spacer layer (4) is in contact with a backside reflector layer (5), further comprising a gate line (12) which is in contact with the backside reflector layer (5), wherein there is no overlap between the gate line (12) and the signal line (11).

5. The photodetector (8) according to one of claims 1 to 4, wherein the insulator spacer layer (4) is in contact with a backside reflector layer (5), wherein the resonator layer (1) includes first contact lines (1a1) and second contact lines (1a2) having different materials and being arranged in an alternating fashion, wherein an electrical measurement instrumentation (13) is connected between the first contact lines (1a1) and the second contact lines (1a2), and wherein a voltage source (14) is connected to the second contact lines (1a1) and to the backside reflector layer (5), wherein the voltage of the voltage source (14) is adjusted to maximize charge carrier velocity .

6. The photodetector (8) according to one of claims 1 to 5, configured according to a procedure to maximize a measured electrical current (I_load) on the basis of an equivalent circuit (15) of the photodetector (8) under illumination.

7. The photodetector (8) according to one of claims 1 to 6, wherein a 2D material insulator (4a) is arranged between the spacer layer (4) and the 2D material layer (3).

8. The photodetector (8) according to one of claims 1 to 7, wherein the resonator layer (1) includes first resonators (1b) connected to contact lines (1a), wherein second resonators (1bb) are arranged in an orthogonal fashion with respect to the first resonators (1bb), wherein the second resonators (1bb) are connected to the contact lines (1a).

9. The photodetector (8) according to one of claims 1 to 8, wherein the resonator layer (1) includes a plurality of resonators (1b, 1bb, 1bbb) having different geometries.

10. The photodetector (8) according to one of claims 1 to 9, wherein a frontside 2D material insulator (7a) which is in contact with the 2D material layer (2) in a configuration which enables that the 2D material layer (3) remains in contact with the resonator layer (1).

11. The photodetector (8) according to one of claims 1 to 10, wherein the resonator layer (1) includes first contact lines (1a1) connected to resonators (1b), and wherein the resonator layer (1) includes second contact lines (1a2) without resonators (1b).

12. The photodetector (8) according to one of claims 1 to 11, wherein the spacer layer (4) is in contact with an optical waveguide (16).
